# EUROPÄISCHE PATENTSCHRIFT

(11) **EP 1 282 345 B1**
(45) Veröffentlichungstag und Bekanntmachung des Hinweises auf die Patenterteilung: **19.03.2008**
(21) Anmeldenummer: 02016811.8
(22) Anmeldetag: 26.07.2002
(51) Int. Cl.: H05K 5/00, H05K 7/14

(54) **Gehäuse zur Aufnahme einer Leiterplatte mit elektronischen Bauteilen in Fahrzeugen**
Housing for board with electronic components in vehicle
Boîtier abritant une carte électronique avec ses composants dans un véhicule

(30) Priorität: 31.07.2001 DE 20112595 U
(43) Veröffentlichungstag der Anmeldung: 05.02.2003
(73) Patentinhaber: TRW Automotive Electronics & Components GmbH & Co. KG, 78315 Radolfzell (DE)
(72) Erfinder: Skofljanec, Robert, 78345 Moos-Bankholzen (DE)
(74) Vertreter: Degwert, Hartmut

(56) Entgegenhaltungen:
- DE-A1- 19 738 803
- US-A- 5 608 611
- US-A- 5 872 332

## Beschreibung

An ein solches Gehäuse werden die verschiedensten Anforderungen gestellt: So sollte es möglichst kostengünstig herstellbar und möglichst platzsparend ausgeführt sein. Vorteilhaft ist auch, wenn das gleiche Gehäuse unabhängig von dem Einbauort und den dort vorgebenen Einbaubedingungen sowie der Gestaltung der Leiterplatte verwendet werden kann bzw. wenn das Gehäuse durch einfach auszuführende Änderungen problemlos an die Einbaubedingungen und/oder an die Gestaltung der Leiterplatte angepaßt werden kann. Bisherige aus dem Stand der Technik bekannte Gehäuse weisen beispielsweise ein als Verbundkörper ausgebildetes Gehäuse auf, das aus einer metallischen Grundplatte und einem Kunststoffkörper besteht. Die Grundplatte überragt den Kunststoffkörper auf zwei Seiten und weist an den überragenden Randstreifen Befestigungsöffnungen auf, an denen das Gehäuse beispielsweise an der Fahrzeugkarosserie befestigt werden kann. Die Lage der Befestigungpunkte sowie die äußere Gestalt des Gehäuses ist festgelegt. Die elektrische Kontaktierung der Leiterplatte zur Grundplatte erfolgt beispielsweise durch eine aus der Grundplatte freigestanzte und in Richtung der Leiterplatte hochgebogene Lasche.

Andere Gehäuse zur Aufnahme einer Leiterplatte bzw. Sensor in Fahrzeugen in denen metallische Buchsen verwendet werden sind aus US-A-5 872 332, US-A-5 608 611 und DE-A-19 738 803 bekannt.

Durch die vorliegende Erfindung, die in den Patentansprüchen definiert ist, wird ein Gehäuse bereitgestellt, das bei kompakter Bauweise eine optimale Leiterplattenausnützung bietet und das besonders kostengünstig herstellbar und montierbar ist. Das Gehäuse hat eine allgemein quaderförmige Haube und eine Bodenplatte. Die Leiterplatte ist an wenigstens drei der vier Ecken der Haube mit metallischen Montagebuchsen mechanisch und elektrisch leitend verbunden. Die Haube weist an diesen Ecken je einen Montageflansch auf, und die Montagebuchsen sind in den Montageflanschen der Haube verankert. Die Montagebuchsen durchragen in der Leiterplatte ausgebildete Öffnungen. Da sich die Leiterplatte bis in die Ecken der Bodenplatte und der Haube erstreckt und die Grundplatte nicht die Haube überragt, entsteht so ein sehr kompaktes Gehäuse, dessen Grundfläche fast vollständig als Leiterplattenfläche genutzt werden kann. Gleichzeitig kann über die Montagebuchse eine elektrisch leitende Verbindung zwischen der Leiterplatte und beispielsweise der Fahrzeugkarosserie hergestellt werden. Das einfache "Ineinanderstecken" der einzelnen Bauteile sowie die geringe Anzahl verschiedener Bauteile ermöglicht eine schnelle, einfache und damit kostengünstige Montage.

Gemäß einer bevorzugten Ausführungsform weist die Haube senkrecht über den Montageflanschen Einbuchtungen auf, die einem Werkzeug den Zugang zu durch die Montagebuchsen eingesetzten Befestigungsschrauben erleichtert. Damit ist das Gehäuse einfach montierbar, beispielsweise an der Karosserie eines Fahrzeugs.

Gemäß einer weiteren bevorzugten Ausführungsform ist der Steckerkragen optional an einer langen oder an einer kurzen Schmalseite der Haube angeordnet. Bei Anordnung an einer kurzen Schmalseite reicht der Steckerkragen bis an den Bereich derjenigen der vier Ecken der Haube heran, an der keine Montagebuchse vorgesehen ist, so daß das Gehäuse nur noch über die restlichen drei Montagebuchsen befestigt wird. Dadurch, daß man von den vier möglichen Montagebuchsen nur drei zur Befestigung benutzt, besteht eine relativ große Freiheit bezüglich der Auswahl der Befestigungspunkte. Die Möglichkeit, den Steckerkragen wahlweise an einer der beiden aneinander angrenzenden Schmalseiten anzubringen, erlaubt, die äußere Form des Gehäuses an die Einbaubedingungen anzupassen, und gibt mehr Freiheit bezüglich der Gestaltung der Leiterplatte.

Weitere Vorteile und Merkmale ergeben sich aus der folgenden Beschreibung mehrerer Ausführungsformen und aus den Zeichnungen, auf die Bezug genommen wird. In den Zeichnungen zeigen:
Figur 1 in einer perspektivischen Ansicht eine allgemein quaderförmige Haube eines erfindungsgemäßen Gehäuses;
Figur 2 in einer Explosionsdarstellung die einzelnen Komponenten eines erfindungsgemäßen Gehäuses;
Figur 3 in einer schematischen Schnittansicht das erfindungsgemäße Gehäuse von Figur 2;
Figuren 4a bis 4c in einer schematischen Ansicht von oben verschiedene Möglichkeiten der Anformung des Steckerkragens an die Haube.

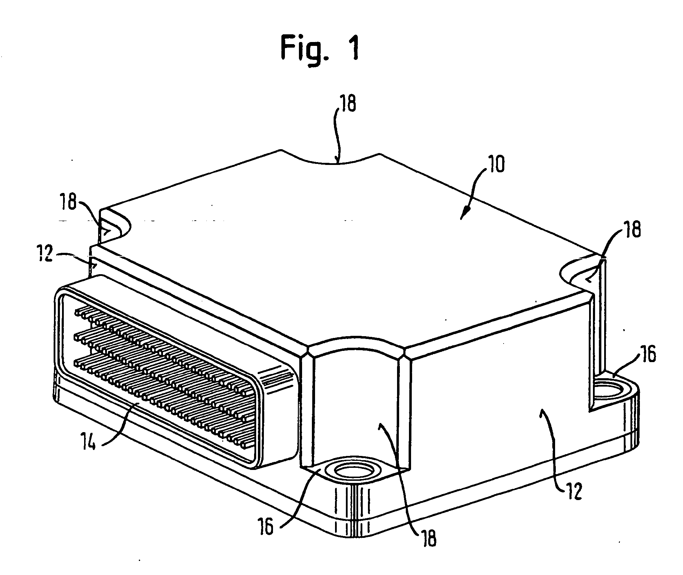

In Figur 1 ist eine Haube 10 eines erfindungsgemäßen Gehäuses abgebildet. Die allgemein quaderförmige Haube 10 besteht aus Kunststoff. In einer ihrer Schmalseiten 12 ist ein Steckerkragen 14 eingesetzt. Der Steckerkragen 14 kann aber auch gemäß einer weiteren Ausführungsform an der Haube angeformt sein. An jeder ihrer Ecken ist ein Montageflansch 16 vorgesehen. Senkrecht über jedem Montageflansch 16 weist die Haube 10 Einbuchtungen 18 auf, die den Zugang eines zur Montage des Gehäuses notwendigen Werkzeugs erleichtern.

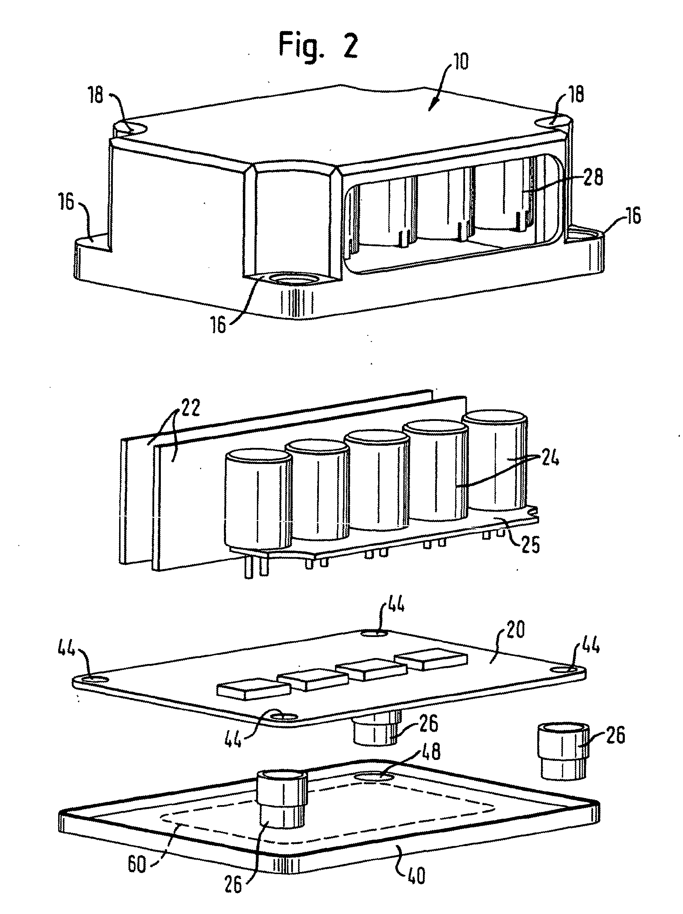

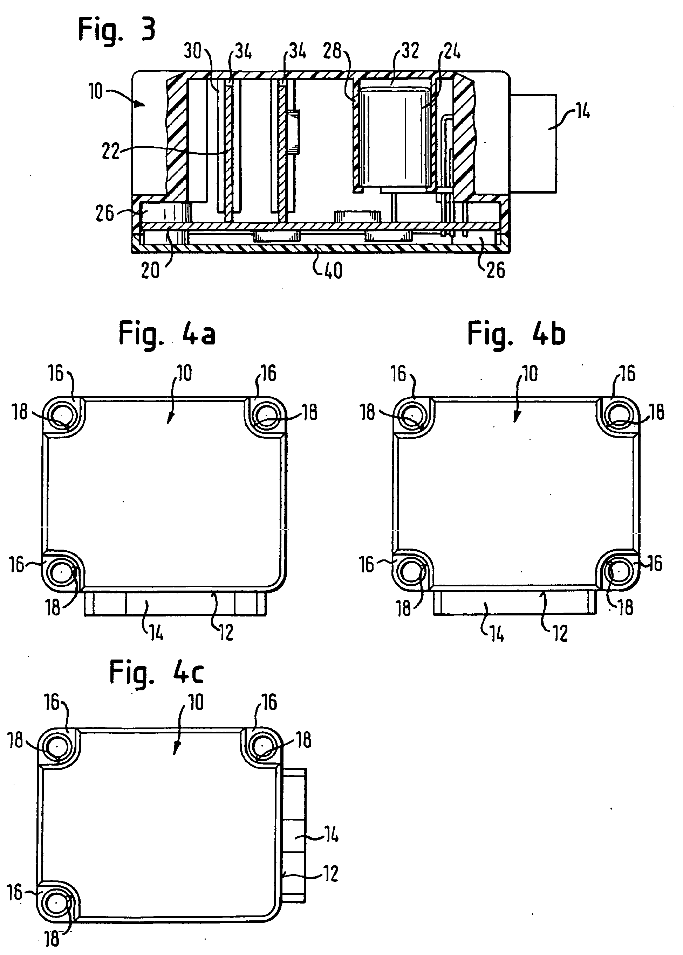

Die in Figur 2 abgebildete Explosionsdarstellung zeigt schematisch die einzelnen Komponenten eines erfindungsgemäßen Gehäuses und deren Zusammenwirken. In Figur 3 ist das montierte Gehäuse aus Figur 2 in einer schematischen Schnittansicht dargestellt. Neben der oben beschriebenen Haube 10 sind in Figur 2 verschiedene Leiterplatten 20, 22 und Kondensatoren 24, die von dem Gehäuse aufgenommen werden sollen und die auf einer Leiterplatte 25 angeordnet sind, sowie metallische Montagebuchsen 26 und eine Bodenplatte 40 abgebildet. Zur Aufnahme und Positionierung der Kondensatoren 24 bzw. der Leiterplatten 22 sind an der Haube 10 entsprechende Aufnahmeelemente 28 bzw. 30 (siehe auch Figur 3) ausgebildet, die Aussparungen 32 bzw. 34 für die Kondensatoren 24 und die Leiterplatten 22 bilden. Nach dem Einsetzen der Kondensatoren 24 in die Aussparungen 32 und dem Einsetzen der Leiterplatten 22 in die Aussparungen 34 der Haube 10 wird die bestückte Leiterplatte 20 von bezüglich Figur 2 unten an die Montageflansche 16 der Haube 10 angelegt. Sind die Montagebuchsen 26 in das Kunststoffmaterial der Haube eingeformt, wird die Leiterplatte 20 an Öffnungen 44 auf die Montagebuchsen 26 aufgesetzt und mit diesen verbunden, z.B. durch Verpressen der Montagebuchsen 26, so daß neben der mechanischen Verbindung der Leiterplatte 20 mit den metallischen Montagebuchsen 26 auch eine elektrisch leitende Verbindung zu Leiterbahnen auf der Leiterplatte hergestellt werden kann. Die vier Montagebuchsen 26 sind jeweils durch elektrische Leiterbahnen auf der Leiterplatte 20 elektrisch leitend miteinander verbunden. Alternativ zu der Ausführungsform mit den Montagebuchsen, die in das Kunststoffmaterial der Haube eingeformt sind, ist es auch vorgesehen, daß die Montagebuchsen 26 vor der Montage der Leiterplatte 20 in das Gehäuse 10 in die Öffnungen 44 der Leiterplatte 20 eingesetzt und mit dieser verpreßt werden. In diesem Fall weisen die Montageflansche 16 zur Abdichtung des Gehäuses je eine Dichthülse aus Elastomer-Material auf. Diese Dichthülsen sind bevorzugterweise mit der Haube in 2-Komponenten-Spritztechnik hergestellt. Die zu der Leiterplatte 20 verpressten Montagebuchsen 26 werden dann in die Montageflansche 16 eingesetzt. Bei dieser Ausführungsform ist die Oberfläche der Montagebuchsen, die in Kontakt mit den Dichthülsen kommt, bevorzugterweise gerändelt ausgeführt, um eine bessere Abdichtung zu erreichen.

Anschließend wird die Bodenplatte 40, die bevorzugterweise aus Kunststoff gebildet ist, an ihren Öffnungen 48 auf die Montagebuchsen 26 aufgesetzt. Eine Befestigung der Bodenplatte 40 mit der Haube 10 kann dann durch übliche Methoden wie durch Kleben, Laserschweissen oder durch heißes Verstemmen erfolgen.

Das montierte Gehäuse kann anschließend über in die Montageflansche 16 eingesetzte Befestigungsschrauben an dem vorgesehenen Einbauort, beispielsweise an der Fahrzeugkarosserie, montiert werden. Die Einbaulage und die äußere Gestaltung des Gehäuses kann abhängig von dem Einbauort und/oder der eingebauten Leiterplatte variiert werden, wie im folgenden anhand von Figur 4 erläutert werden soll:
In Figur 4 sind zwei mögliche Varianten der Anformung des Steckerkragens an der Haube und der Lage bzw. der Anzahl der Befestigungspunkte des Gehäuses zu sehen.

In den Figuren 4a und 4b ist der Steckerkragen 14 jeweils an einer der langen Schmalseiten 12 der Haube 10 angeordnet. In Figur 4a erstreckt sich der Steckerkragen 14 bis an die bezüglich Figur 4 untere rechte Ecke der Haube 10. An dieser Ecke der Haube 10 ist kein Montageflansch ausgebildet. Das Gehäuse kann über die restlichen drei Montageflansche 16 der Haube 10 befestigt werden. In Figur 4b erstreckt sich der Steckerkragen 14 zwischen den beiden unteren Montageflanschen 26 der Haube 10, so daß vier Montageflansche 16 vorgesehen sind und zur Befestigung des Gehäuses genutzt werden können.

In Figur 4c ist der Steckerkragen 14 an einer der kurzen Schmalseiten 12 der Haube 10 angeordnet. Er reicht bis an die bezüglich Figur 4 untere rechte Ecke der Haube 10 heran, an der kein Montageflansch ausgebildet ist. Wie in Figur 4a sind nur drei Montageflansche 16 zur Befestigung des Gehäuses vorgesehen. Da der Steckerkragen 14 im Unterschied zur Figur 4a an einer der kurzen Schmalseiten der Haube 10 und nicht an einer der langen Schmalseiten der Haube 10 angeordnet ist, kann die Länge des Steckerkragens 14 sowie die gesamte äußere Form des Gehäuses über die Variation der Steckerkragenlage verändert werden.

Gemäß der Erfindung ist ferner vorgesehen, daß die Bodenplatte 40 wahlweise stellenweise verdünnt ausgeführt ist, so daß zu Reparaturzwecken die Bodenplatte 40 an den verdünnt ausgeführten Stellen 60 aufgebrochen werden kann und die Leiterplatten 20, 22, 25 bzw. die Kondensatoren 24 entnommen werden können.

## Patentansprüche

1. Gehäuse zur Aufnahme mindestens einer Leiterplatte (20, 22) mit elektronischen Bauteilen in Fahrzeugen, mit einer allgemein quaderförmigen Haube (10) aus Kunststoff und einer die Haube (10) verschließenden Bodenplatte (40), **dadurch gekennzeichnet, dass** die Leiterplatte (20) an wenigstens drei der vier Ecken der Haube (10) mit metallischen Montagebuchsen (26) mechanisch und elektrisch leitend verbunden ist, die Haube (10) an diesen Ecken je einen Montageflansch (16) aufweist und die Montagebuchsen (26) in den Montageflanschen (16) der Haube (10) verankert sind.

2. Gehäuse nach Anspruch 1, **dadurch gekennzeichnet, dass** die Haube (10) senkrecht über den Montageflanschen (16) Einbuchtungen (18) für den Zugang eines Werkzeugs zu durch die Montagebuchsen (26) eingesetzten Befestigungsschrauben aufweist

3. Gehäuse nach Anspruch 1 oder 2, **dadurch gekennzeichnet, dass** ein Steckerkragen (14) optional an einer langen oder an einer kurzen Seitenwand (12) der Haube (10) angeordnet ist und bei Anordnung an einer kurzen Seitenwand (12) bis an den Bereich derjenigen der vier Ecken der Haube (10) heranreicht, an der keine Montagebuchse (26) vorgesehen ist.

4. Gehäuse nach einem der Ansprüche 1 bis 3, **dadurch gekennzeichnet, dass** die Montagebuchsen (26) mit der Leiterplatte (20) verpresst sind.

5. Gehäuse nach einem der Ansprüche 1 bis 4, **dadurch gekennzeichnet, dass** die Montagebuchsen (26) in das Kunststoffmaterial der Haube (10) eingeformt sind.

6. Gehäuse nach einem der Ansprüche 1 bis 4, **dadurch gekennzeichnet, dass** die Montageflansche (16) zur dichtenden Aufnahme der Montagebuchsen (26) je eine Dichthülse aus Elastomer-Material aufweisen.

7. Gehäuse nach Anspruch 6, **dadurch gekennzeichnet, dass** die Dichthülsen in 2-Komponenten- Spritztechnik mit der Haube (10) hergestellt sind.

8. Gehäuse nach einem der vorhergehenden Ansprüche, **dadurch gekennzeichnet, daß** der Steckerkragen (14) an der Haube (10) angeformt ist.

9. Gehäuse nach einem der vorhergehenden Ansprüche, **dadurch gekennzeichnet, daß** die Haube (10) und die Bodenplatte (40) miteinander verschweißt sind.

## Claims

1. A housing for accommodating at least one printed circuit board (20, 22) carrying electronic components in a vehicle, comprising a generally parallelepipedal hood (10) made of plastic and a base plate (40) closing off the hood (10), **characterized in that** the printed circuit board (20) is mechanically attached and electrically conductively connected to metallic mounting bushings (26) at least at three of the four corners of the hood (10), that the hood (10) has a mounting flange (16) at each of these corners, and that the mounting bushings (26) are anchored in the mounting flanges (16) of the hood (10).

2. The housing according to claim 1, **characterized in that** the hood (10) has indentations (18) perpendicularly above the mounting flanges (16) to permit access with a tool to fastening screws inserted through the mounting bushings (26).

3. The housing according to claim 1 or 2, **characterized in that** a plug collar (14) is optionally arranged on a long or a short side wall (12) of the hood (10) and, if it is arranged on a short side wall (12), the plug collar extends as far as to the area of that one of the four corners of the hood (10) where no mounting bushing (26) is provided.

4. The housing according to any of claims 1 to 3, **characterized in that** the mounting bushings (26) are press-fitted with the printed circuit board (20).

5. The housing according to any of claims 1 to 4, **characterized in that** the mounting bushings (26) are molded into the plastic material of the hood (10).

6. The housing according to any of claims 1 to 4, **characterized in that** the mounting flanges (16) each have a sealing sleeve made of an elastomer material for sealingly receiving the mounting bushings (26).

7. The housing according to claim 6, **characterized in that** the sealing sleeves are manufactured together with the hood (10) by a two-component injection molding method.

8. The housing according to any of the preceding claims, **characterized in that** the plug collar (14) is integrally molded with the hood (10).

9. The housing according to any of the preceding c!aims, **characterized in that** the hood (10) and the base plate (40) are connected with each other by welding.

## Revendications

1. Boîtier de réception d'au moins une carte de circuit imprimé (20, 22) à composants électroniques de véhicules, comportant un couvercle (10) généralement parallélépipédique en matière plastique et une plaque de fond (40) fermant le couvercle (10), **caractérisé en ce que** la carte de circuit imprimé (20) est reliée de façon mécanique et électroconductrice, sur au moins trois des quatre coins du couvercle (10), avec des douilles de montage métalliques, le couvercle (10) présente dans chacun de ces coins une bride de montage (16) et les douilles de montage (26) sont ancrées dans les brides de montage (16) du couvercle (10).

2. Boîtier selon la revendication 1, **caractérisé en ce que** le couvercle (10) présente perpendiculairement au-dessus des brides de montage (16), des échancrures (18) pour l'accès d'un outil à des vis de fixation insérées à travers les douilles de montage (26).

3. Boîtier selon la revendication 1 ou 2, **caractérisé en ce qu'**un collet de fiche (14) est agencé en option sur une paroi latérale (12) longue ou sur une paroi latérale (12) courte du couvercle (10) et, dans le cas d'un agencement sur une paroi latérale (12) courte, il va jusqu'à la zone de celui des quatre coins du couvercle (10) sur lequel il n'est pas prévu de douille de montage (26).

4. Boîtier selon l'une des revendications 1 à 3, **caractérisé en ce que** les douilles de montage (26) sont pressées avec la carte de circuit imprimé (20).

5. Boîtier selon l'une des revendications 1 à 4, **caractérisé en ce que** les douilles de montage (26) sont moulées dans la matière plastique du couvercle (10).

6. Boîtier selon l'une des revendications 1 à 4, **caractérisé en ce que** les brides de montage (16) présentent chacune une gaine d'étanchéité en matériau élastomère pour recevoir de manière étanche les douilles de montage (26).

7. Boîtier selon la revendication 6, **caractérisé en ce que** les gaines d'étanchéité sont fabriquées avec le couvercle (10) par technique de moulage par injection à deux composants.

8. Boîtier selon l'une des revendications précédentes, **caractérisé en ce que** le collet de fiche (14) est moulé sur le couvercle (10).

9. Boîtier selon l'une des revendications précédentes, **caractérisé en ce que** le couvercle (10) et la plaque de fond (40) sont soudés l'un à l'autre.
